# EUROPÄISCHE PATENTANMELDUNG

(11) **EP 3 917 295 A1**
(43) Veröffentlichungstag der Anmeldung: **01.12.2021**
(21) Anmeldenummer: 21176599.5
(22) Anmeldetag: 28.05.2021
(51) Int. Cl.: H05K 3/12, B60R 16/02, H05K 3/46, H05K 1/09

(54) **VERFAHREN ZUR HERSTELLUNG EINES ELEKTRISCHEN VERTEILERSYSTEMS UND ELEKTRISCHES VERTEILERSYSTEM**

(30) Priorität: 29.05.2020 DE 102020114548
(71) Anmelder: Yazaki Systems Technologies GmbH, 93059 Regensburg (DE)
(72) Erfinder: NAVARRO MÁLAGA, Aldo, 73730 Esslingen am Neckar (DE); EINERT, Martin, 93077 Bad Abbach (DE)
(74) Vertreter: Patentanwaltskanzlei WILHELM & BECK

(57) **Zusammenfassung**

Die Erfindung betrifft ein elektrisches Verteilersystem (10), insbesondere einen Kabelbaum (15), und ein Verfahren zur Herstellung des elektrischen Verteilersystems (10), wobei ein elektrisch nichtleitendes flüssiges Ummantelungsmaterial (90) entlang einer vordefinierten Bahn (135) zur Ausbildung einer ersten Ummantelungsschicht (140) aufgedruckt wird, wobei zeitlich nach Aufbringen des Ummantelungsmaterials (90) ein elektrisch leitfähiges zweites Partikelmaterial (145) auf die erste Ummantelungsschicht (140) zur Ausbildung eines ersten elektrischen Leiters (30) aufgebracht wird, wobei die erste Ummantelungsschicht (140) zumindest teilweise das zweite Partikelmaterial (145) fixiert, wobei das erste Trägermaterial (130) zeitlich nach Aufbringen des zweiten Partikelmaterials (145) zu der ersten Ummantelungsschicht (140) ausgehärtet wird.

## Beschreibung

Die Erfindung betrifft ein Verfahren zur Herstellung eines elektrischen Verteilersystems gemäß Patentanspruch 1 und 9 sowie ein elektrisches Verteilersystem gemäß Patentanspruch 8 und 14.

Aus DE 10 2016 223 284 A1 ist ein Verfahren zur Herstellung eines elektrischen Verteilersystems bekannt.

Es ist Aufgabe der Erfindung, ein verbessertes Verfahren zur Herstellung eines elektrischen Verteilersystems und ein verbessertes elektrisches Verteilersystem bereitzustellen.

Diese Aufgabe wird mittels eines Verfahrens gemäß Patentanspruch 1 und 9 und eines elektrischen Verteilersystems gemäß Patentanspruch 8 und 14 gelöst. Vorteilhafte Ausführungsformen sind in den abhängigen Ansprüchen angegeben.

Es wurde erkannt, dass ein verbessertes Verfahren zur Herstellung des elektrischen Verteilersystems dadurch bereitgestellt werden kann, dass ein elektrisch nichtleitendes flüssiges Ummantelungsmaterial entlang einer vordefinierten Bahn zur Ausbildung einer ersten Ummantelungsschicht gedruckt wird, wobei zeitlich nach Aufbringen des Ummantelungsmaterials ein elektrisch leitfähiges zweites Partikelmaterial auf die erste Ummantelungsschicht zur Ausbildung eines ersten elektrischen Leiters aufgebracht wird, wobei die erste Ummantelungsschicht zumindest teilweise das zweite Partikelmaterial fixiert, wobei das erste Trägermaterial zeitlich nach Aufbringen des zweiten Partikelmaterials zu der ersten Ummantelungsschicht ausgehärtet wird.

Diese Ausgestaltung hat den Vorteil, dass der erste elektrische Leiter, der durch das erste Partikelmaterial ausgebildet wird, einen besonders niedrigen elektrischen ohmschen Widerstand aufweist und somit zur Hochstromübertragung (größer 10 A) geeignet ist.

Besonders von Vorteil ist, wenn zumindest teilweise das elektrisch leitfähige zweite Partikelmaterial auf das flüssige und/oder teilweise ausgehärtete Ummantelungsmaterial der ersten Ummantelungsschicht aufgebracht wird, wobei das zweite Partikelmaterial zumindest teilweise durch das Ummantelungsmaterial umschlossen wird. Dadurch wird das zweite Partikelmaterial besonders gut gehalten.

In einer weiteren Ausführungsform wird zur Herstellung der ersten Ummantelungsschicht eine erste Lage des Ummantelungsmaterials aufgebracht und ausgehärtet, wobei zeitlich nach Aushärten der ersten Lage der ersten Ummantelungsschicht eine zweite Lage der ersten Ummantelungsschicht auf die erste Lage aufgebracht wird. Das zweite Partikelmaterial wird auf das flüssige und/oder teilweise ausgehärtete Ummantelungsmaterial der zweiten Lage aufgebracht. Dadurch kann ein tiefes Absacken des zweiten Partikelmaterials verhindert werden, sodass das zweite Partikelmaterial konzentriert an/in der zweiten Lage angeordnet ist. Dadurch wird ein besonders niedriger elektrischer Widerstand des elektrischen Leiters sichergestellt.

Ferner ist von Vorteil, wenn zeitlich nach Aufbringen des zweiten Partikelmaterials das flüssige und/oder teilweise ausgehärtete Ummantelungsmaterial der zweiten Lage fertig ausgehärtet wird, wobei zeitlich nach Ausbilden des ersten elektrischen Leiters die erste Ummantelungsschicht unter Hitzeeinwirkung zumindest teilweise von dem ersten elektrischen Leiter entfernt wird. Dadurch ist das elektrische Verteilersystem besonders dünn. Das zweite Partikelmaterial wird unter Hitzeeinwirkung gesintert und/oder zumindest teilweise zur Ausbildung des ersten elektrischen Leiters aufgeschmolzen. Dadurch weist der erste elektrische Leiter einen besonders niedrigen elektrischen Widerstand auf, wobei das zweite Partikelmaterial zu einem einheitlichen Material verbunden wird.

In einer weiteren Ausführungsform wird auf das zweite Partikelmaterial das Ummantelungsmaterial zur Ausbildung einer zweiten Ummantelungsschicht aufgedruckt und zu der zweiten Ummantelungsschicht ausgehärtet. Das Ummantelungsmaterial fixiert zumindest teilweise das zweite Partikelmaterial.

In einer weiteren Ausführungsform wird ein elektrisch leitfähiges drittes Partikelmaterial auf die zweite Ummantelungsschicht zur Ausbildung eines zweiten elektrischen Leiters aufgebracht, wobei die zweite Ummantelungsschicht zumindest teilweise das dritte Partikelmaterial fixiert, wobei das Ummantelungsmaterial der zweiten Ummantelungsschicht zeitlich nach Aufbringen des zweiten Partikelmaterials zu der zweiten Ummantelungsschicht ausgehärtet wird und das zweite Partikelmaterial den zweiten elektrischen Leiter ausbildet. Von besonderem Vorteil ist hierbei, wenn das dritte Partikelmaterial auf das flüssige und/oder teilweise ausgehärtete Ummantelungsmaterial der zweiten Ummantelungsschicht aufgebracht wird. Dadurch wird das dritte Partikelmaterial durch das zweite Trägermaterial fixiert.

Das elektrische Verteilersystem, insbesondere der Kabelbaum, weist eine Ummantelung und wenigstens einen ersten elektrischen Leiter auf, wobei die Ummantelung gedruckt ist, insbesondere 3D-gedruckt, und der elektrische Leiter in die Ummantelung gegossen oder gedruckt ist, wobei die Ummantelung zumindest abschnittsweite den ersten elektrischen Leiter umschließt.

Ferner wurde erkannt, dass ein verbessertes Verfahren zur Herstellung eines elektrischen Verteilersystems, insbesondere eines Kabelbaums, dadurch bereitgestellt werden kann, dass eine Ummantelung des elektrischen Verteilersystems mit wenigstens einer Hohlstruktur aus einem elektrisch nichtleitenden flüssigen Ummantelungsmaterial gedruckt wird. Das Ummantelungsmaterial wird ausgehärtet. Ein elektrisch leitfähiger Werkstoff wird in zumindest teilweise flüssigem Aggregatszustand in die Hohlstruktur eingebracht und der elektrisch leitfähige Werkstoff wird zu einem ersten elektrischen Leiter des elektrischen Verteilersystems ausgehärtet.

Diese Ausgestaltung hat den Vorteil, dass auch komplizierte dreidimensionale Verläufe des elektrischen Verteilersystems hergestellt werden können, sodass ein Knicken und möglicherweise dabei ein Beschädigen eines aus Draht gefertigten elektrischen Leiters beim Verlegen des Kabelbaums verhindert werden kann.

In einer weiteren Ausführungsform wird der elektrisch leitfähige Werkstoff zeitlich nach dem Aushärten des Ummantelungsmaterials in die Hohlstruktur eingebracht, wobei vorzugsweise die Hohlstruktur nach dem Aushärten elastisch reversibel um wenigstens 20° um eine Knickachse verformbar ist. Die Hohlstruktur wird im Wesentlichen vollständig mit dem elektrisch leitfähigen Werkstoff verfüllt.

In einer weiteren Ausführungsform wird der elektrisch leitfähige Werkstoff druckbeaufschlagt in die Hohlstruktur eingepresst. Dies stellt sicher, dass die Hohlstruktur vollständig verfüllt ist und zuverlässig der elektrische Leiter zur elektrischen Verbindung zweier Kontakteinrichtungen in der Hohlstruktur ausgeformt werden kann.

Von besonderem Vorteil ist, wenn mittels eines ersten Druckkopfs abschnittsweise das elektrisch nichtleitende flüssige Ummantelungsmaterial gedruckt und die Hohlstruktur mit einem ersten Raum ausgeformt wird. Der elektrisch leitfähige Werkstoff wird in den ersten Raum eingebracht. Dies kann beispielsweise mittels eines zweiten Druckkopfs erfolgen, der den elektrisch leitfähigen Werkstoff in den ersten Raum druckt. Der elektrisch leitfähige Werkstoff kann beispielsweise ein elektrisch leitfähiger Kunststoff, beispielsweise mit erstem Partikelmaterial, oder ein intrinsischer Kunststoff sein. Das Drucken der Ummantelung und das Einbringen des leitfähigen Werkstoffs in den ersten Raum erfolgt im Wesentlichen zeitgleich. Dadurch ist die Herstellungszeit zur Herstellung des elektrischen Verteilersystems besonders kurz.

In einer weiteren Ausführungsform weist der elektrisch leitfähige Werkstoff bei Befüllung der Hohlstruktur ein Gemisch aus wenigstens einem ersten Vorprodukt eines ersten Matrixmaterials und einem elektrisch leitfähigen ersten Partikelmaterial auf, wobei das erste Vorprodukt zu dem ersten Matrixmaterial ausgehärtet wird und eine stoffschlüssige Verbindung zu der Hohlstruktur ausbildet. Das erste Partikelmaterial ist in dem ersten Matrixmaterial eingebettet und stellt die elektrische Leitfähigkeit des ausgehärteten elektrisch leitfähigen Werkstoffs zur Ausbildung des ersten elektrischen Leiters sicher.

Nachfolgend wird die Erfindung anhand von Figuren näher erläutert. Dabei zeigen:
Figur 1 eine schematische Darstellung eines elektrischen Verteilersystems;
Figur 2 eine Schnittansicht entlang einer in Figur 1 gezeigten Schnittebene A-A durch das in Figur 1 gezeigte elektrische Verteilersystem;
Figur 3 ein Ablaufdiagramm eines Verfahrens zur Herstellung des in den Figuren 1 und 2 gezeigten elektrischen Verteilersystems;
Figur 4 eine schematische Darstellung des elektrischen Verteilersystems während eines ersten Verfahrensschritts;
Figur 5 eine Draufsicht auf eine gedruckte Hohlstruktur nach dem ersten Verfahrensschritt;
Figur 6 eine schematische Darstellung eines elektrischen Verteilersystems während des ersten Verfahrensschritts in einem Herstellungsverfahren gemäß einer zweiten Ausführungsform;
Figur 7 eine schematische Darstellung des elektrischen Verteilersystems während eines dritten Verfahrensschritts in dem Herstellungsverfahren gemäß der zweiten Ausführungsform;
Figur 8 ein Ablaufdiagramm eines Verfahrens zur Herstellung einer Weiterbildung des in Figur 1 gezeigten Verteilersystems;
Figur 9 einen Ausschnitt einer schematischen Darstellung eines elektrischen Verteilersystems während eines ersten Verfahrensschritts in einem Herstellungsverfahren gemäß einer dritten Ausführungsform zur Herstellung der Weiterbildung des Verteilersystems; und
Figuren 10 und 11 jeweils einen Ausschnitt einer Schnittansicht des in Figur 9 gezeigten elektrischen Verteilersystems nach einem zweiten und einem siebten Verfahrensschritt.

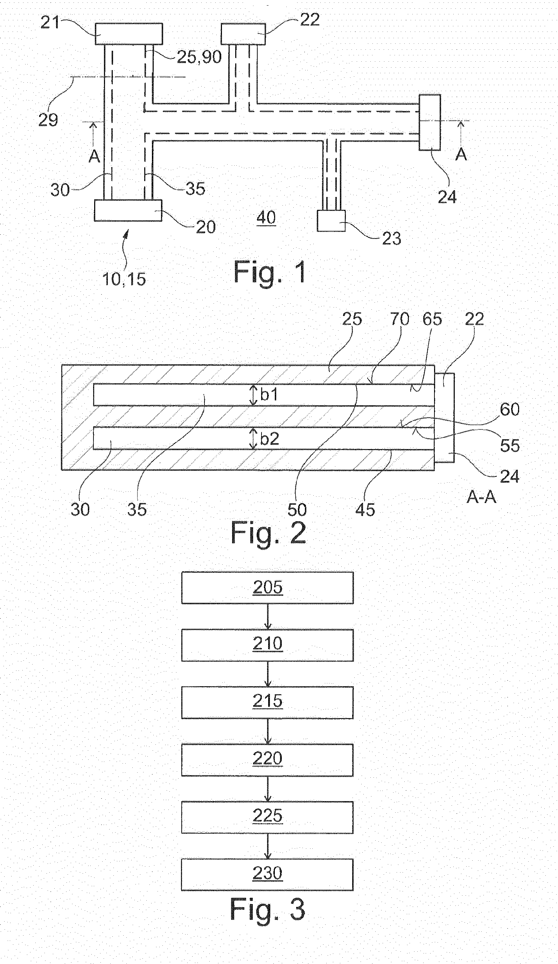

Figur 1 zeigt eine schematische Darstellung eines elektrischen Verteilersystems 10.

Das elektrische Verteilersystem 10 ist beispielhaft als Kabelbaum 15 für ein Kraftfahrzeug ausgebildet. Auch wäre denkbar, dass das elektrische Verteilersystem 10 in Weißware, beispielsweise Waschmaschine oder Spülmaschine oder einem Flugzeug eingesetzt wird.

Das elektrische Verteilersystem 10 weist wenigstens eine Kontakteinrichtung 20, vorzugsweise mehrere Kontakteinrichtungen 20 bis 24 auf. Ferner weist das elektrische Verteilersystem 10 eine Ummantelung 25 auf. Die Ummantelung 25 weist ein elektrisch nichtleitfähiges Ummantelungsmaterial 90 auf. Das Ummantelungsmaterial 90 kann beispielsweise Polyethylen, Silikon, Thermoplast aufweisen. Das Ummantelungsmaterial 90 ist in ausgehärtetem Zustand elastisch. Dabei kann das Ummantelungsmaterial 90 um wenigstens 20°, vorzugsweise um wenigstens 40°, insbesondere um wenigstens 80° um eine Knickachse 29 reversibel (beispielsweise um wenigstens 20 Mal) gebogen werden, ohne dass das Ummantelungsmaterial 90 mechanisch und/oder strukturell beschädigt wird. Die Ummantelung 25 ist beispielsweise 3D-gedruckt.

Das elektrische Verteilersystem 10 weist wenigstens einen, vorzugsweise mehrere elektrische Leiter 30, 35 auf (in Figur 1 strichliert angedeutet). Der elektrische Leiter 30, 35 ist leiterbahnartig ausgebildet und ist durch die Ummantelung 25 umschlossen. Weist das elektrische Verteilersystem 10 mehrere elektrische Leiter 30, 35 auf, so isoliert elektrisch die Ummantelung 25 die elektrischen Leiter 30, 35 sowohl gegeneinander als auch gegenüber einer Umgebung 40. Der elektrische Leiter 30, 35 ist elektrisch mit zumindest einer, vorzugsweise mehreren der Kontakteinrichtungen 20 bis 24 elektrisch und vorzugsweise mechanisch verbunden und verbindet die erste bis fünfte Kontakteinrichtung 20 bis 24 untereinander. Die Anordnung und/oder Anzahl der Kontakteinrichtungen 20 bis 24 ist beispielhaft.

Die erste bis vierte Kontakteinrichtung 20 bis 24 kann mit einem Steuergerät oder einer Komponente eines Kraftfahrzeugs jeweils verbunden sein.

Figur 2 zeigt eine Schnittansicht entlang einer in Figur 1 gezeigten Schnittebene A-A durch das in Figur 1 gezeigte elektrische Verteilersystem 10.

Das Verteilersystem 10 ist schichtartig ausgebildet. Dabei weist die Ummantelung 25 beispielsweise einen schichtartigen, 3D-gedruckten Aufbau auf. In der Ummantelung 25 ist der elektrische Leiter 30, 35 eingebettet. Dabei wird unter einem Einbetten verstanden, dass vollständig der elektrische Leiter 30, 35 durch die Ummantelung 25 zumindest umfangsseitig umschlossen ist.

Die Ummantelung 25 begrenzt einen ersten Raum 45 und beispielsweise einen zweiten Raum 50. Der erste Raum 45 ist nicht mit dem zweiten Raum 50 verbunden. Der erste Raum 45 wird durch eine erste innere Umfangsseite 55 durch die Ummantelung 25 begrenzt. Der erste Raum 45 weist in der Ausführungsform beispielhaft eine rechteckförmige Ausgestaltung auf. Auch kann der erste Raum 45 eine andere Form im Querschnitt, beispielsweise eine polygonförmige, insbesondere eine sechseckförmige, aufweisen.

Der zweite Raum 50 kann im Wesentlichen beispielhaft identisch zu dem ersten Raum 45 ausgebildet sein. Auch kann der zweite Raum 50 andersartig verlaufend oder geometrisch ausgebildet als der erste Raum 45 ausgebildet sein. Die Anzahl der elektrischen Leiter 30, 35 und die Ausgestaltung des Raums 45, 50 dienen nur dazu, den Aufbau des elektrischen Verteilersystems 10 symbolisch zu erläutern.

In der Ausführungsform ist beispielhaft in Figur 2 der zweite Raum 50 oberhalb versetzt zu dem ersten Raum 45 angeordnet. Auch könnte der zweite Raum 50 zusätzlich oder alternativ seitlich versetzt zu dem ersten Raum 45 angeordnet sein. Der zweite Raum 50 weist eine zweite innere Umfangsseite 65 auf. Die zweite innere Umfangsseite 65 kann identisch zu der ersten inneren Umfangsseite 55 ausgebildet sein. Der erste Raum 45 ist mit einem ersten elektrischen Leiter 30 im Wesentlichen vollständig ausgefüllt. An einer ersten äußeren Umfangsseite 60 ist der erste elektrische Leiter 30 stoffschlüssig mit der ersten inneren Umfangsseite 55 verbunden.

Ebenso ist der zweite Raum 50 im Wesentlichen vollständig durch einen im zweiten Raum 50 angeordneten zweiten elektrischen Leiter 35 verfüllt und der zweite elektrische Leiter 35 ist stoffschlüssig mit der Ummantelung 25 verbunden. Der erste elektrische Leiter 30 und der zweite elektrische Leiter 35 sind gegossen, insbesondere spritzgegossen. Der erste elektrische Leiter 30 und/oder der zweite elektrische Leiter 35 weisen die für einen Guss, insbesondere einen Spritzguss, typische Gefügestruktur auf. Der elektrische Leiter 30, 35 ist insbesondere nicht drahtgezogen oder geätzt, sodass eine für das Ziehen oder Ätzen typische Gefügestruktur des ersten und/oder zweiten elektrischen Leiters 30, 35 nicht nachweisbar ist. Auch der zweite elektrische Leiter 35 weist eine stoffschlüssige Verbindung an seiner äußeren ersten Umfangsseite 60 zu der zweiten inneren Umfangsseite 65 des zweiten Raums 50 auf.

Der erste elektrische Leiter 30 und/oder der zweite elektrische Leiter 35 weist einen elektrisch leitfähigen ersten Werkstoff auf. In der Ausführungsform weist der erste Werkstoff ein erstes Matrixmaterial auf, das ausgehärtet ist. Das erste Matrixmaterial kann beispielsweise einen Thermoplast und/oder ein Silikon und/oder einen temperaturstabilen Kunststoff aufweisen. In dem ersten Matrixmaterial kann ein erstes Partikelmaterial eingebettet sein, beispielsweise ein metallisches Partikelmaterial. Zusammen bilden das erste Matrixmaterial und das Partikelmaterial einen elektrisch leitfähigen Kunststoff aus, der ausgehärtet elektrisch die Kontakteinrichtungen 20 bis 24 miteinander verbindet.

Auch kann das erste Matrixmaterial des ersten und/oder zweiten elektrischen Leiters 30, 35 ein intrinsischer Kunststoff sein, wobei auf das Einbetten des ersten Partikelmaterials in dem ersten Matrixmaterial bei dem intrinsischen Kunststoff verzichtet werden kann. Auch dadurch ist der erste und/oder zweite elektrische Leiter 30, 35 elektrisch leitfähig.

Eine erste Schichtdicke b₁ des ersten elektrischen Leiters 30 ist beispielhaft identisch zu einer zweiten Schichtdicke b₂ des zweiten elektrischen Leiters 35. Auch kann die erste Schichtdicke b₁ des ersten elektrischen Leiters 30 unterschiedlich zur zweiten Schichtdicke b₂ des zweiten elektrischen Leiters 35 sein. Diese Ausgestaltung hat den Vorteil, dass an die jeweils zu übertragenden elektrischen Ströme eine Querschnittsfläche des elektrischen Leiters 30, 35, beispielsweise durch Variation der Schichtdicke b₁, b₂ und damit einer Höhe des Raums 45, 50, auf einfache Weise angepasst werden kann.

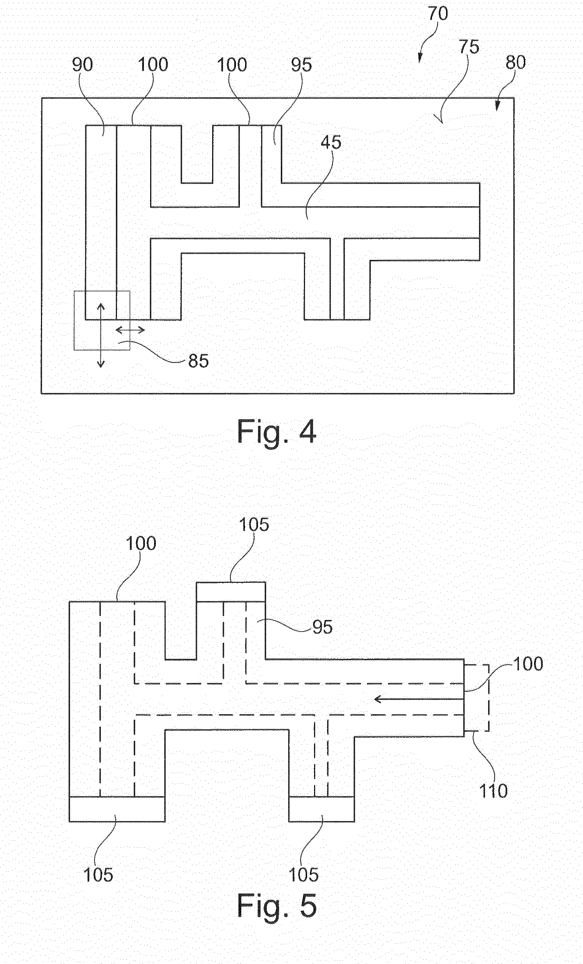

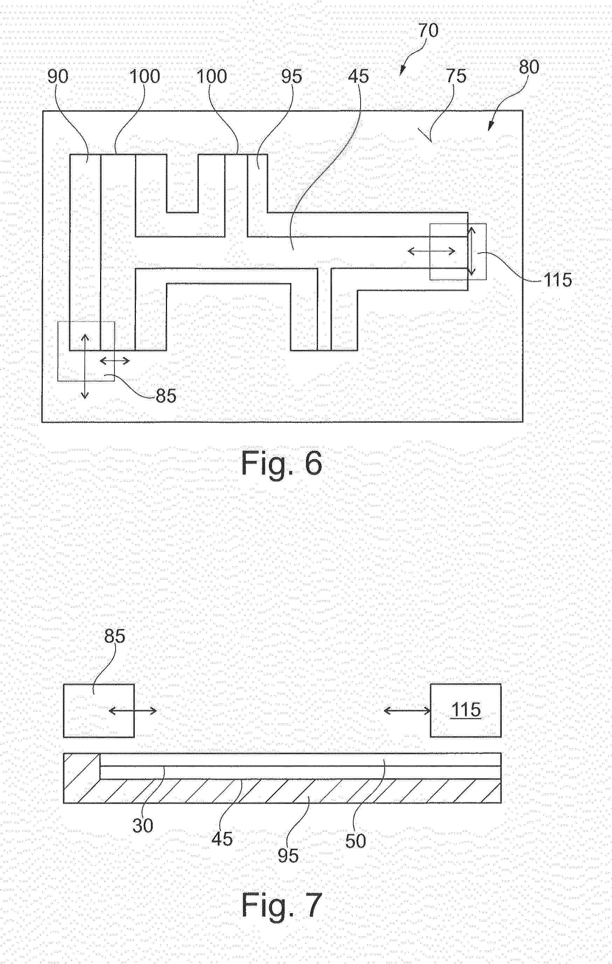

Figur 3 zeigt ein Ablaufdiagramm eines Verfahrens zur Herstellung des in den Figuren 1 und 2 gezeigten elektrischen Verteilersystems 10. Figur 4 zeigt eine schematische Darstellung des elektrischen Verteilersystems 10 während eines ersten Verfahrensschritts 205. Figur 5 zeigt eine Draufsicht auf die gedruckte Hohlstruktur 95 nach dem ersten Verfahrensschritt 205. Figur 6 zeigt eine schematische Darstellung des elektrischen Verteilersystems 10 nach einem dritten Verfahrensschritt 215.

In dem ersten Verfahrensschritt 205 (vgl. Figur 4) wird mittels eines 3D-Druckers 70 auf eine Oberseite 75 einer Platte 80 des 3D-Druckers 70 mittels eines ersten Druckkopfes 85 ein flüssiges, nichtleitendes Ummantelungsmaterial 90 in einem 3D-Druckverfahren auf Grundlage einer vordefinierten Druckgeometrie gedruckt. Dabei können mehrere Einzelschichten des Ummantelungsmaterials 90 übereinander aufgetragen werden, durch die sich eine Hohlstruktur 95 ausbildet. Die Hohlstruktur 95 begrenzt die hohl ausgebildeten Räume 45, 50. Das flüssig aufgetragene Ummantelungsmaterial 90 wird nach Auftrag entweder auf die Platte 80 oder auf eine unter dem aufgetragenen Ummantelungsmaterial 90 liegende Schicht aus bereits ausgehärteten Ummantelungsmaterial 90 ausgehärtet. Dabei wird unter Aushärten verstanden, dass das beim Auftrag flüssige oder zähflüssige Ummantelungsmaterial erstarrt und in einen festen Phasenzustand übergeht. Der Wechsel kann durch Vernetzung des Ummantelungsmaterials und/oder durch einen Phasenübergang von flüssig nach fest erfolgen.

Wird die Hohlstruktur 95 weiter als in Figur 1 gezeigt durch den ersten Druckkopf 85 gedruckt, so wird oberseitig der erste Raum 45 geschlossen. Wird die Hohlstruktur 95 weiter mit dem ersten Druckkopf 85 gedruckt, so wird beispielsweise in der Draufsicht der zweite Raum 50 in seiner konstruktiven Ausgestaltung beispielhaft identisch zu dem ersten Raum 45 durch die Hohlstruktur 95 begrenzt und oberseitig durch einen gedruckten Deckel 96 verschlossen. Der Deckel 96 ist dabei Teil der Hohlstruktur 95.

Zusätzlich kann in einem zweiten Verfahrensschritt 210 jeweils an einer seitlichen Öffnung 100 der Hohlstruktur 95, an die sich in fertig montiertem Zustand des Kabelbaums 15 jeweils die Kontakteinrichtung 20 bis 24 anschließt, ein Verschlussmittel 105, das die Öffnung 100 verschließt, gedruckt werden. Vorteilhafterweise werden zwei möglichst weit beabstandet voneinander angeordnete Öffnungen 100 der Hohlstruktur 95 freigelassen. In der Ausführungsform wird beispielhaft die Öffnung 100 freigelassen, an der später die erste Kontakteinrichtung 20 und die fünfte Kontakteinrichtung 24 befestigt werden. Die anderen Öffnungen 100 werden mit dem Verschlussmittel 105 verschlossen.

Auf den zweiten Verfahrensschritt 210 kann auch verzichtet werden, sodass die Öffnungen 100 der Hohlstruktur 95 offen bleiben.

In einem auf den zweiten Verfahrensschritt 210 folgenden dritten Verfahrensschritt 215, der vorzugsweise erst dann durchgeführt wird, wenn die Hohlstruktur 95 vollständig ausgehärtet ist, wird ein Spritzgusswerkzeug 110 (in Figur 5 strichliert dargestellt) an beispielsweise eine der nicht verschlossenen Öffnungen 100 angesetzt. Das Spritzgusswerkzeug 110 drückt druckbeaufschlagt den elektrisch leitfähigen ersten Werkstoff in zumindest teilweise flüssigem Aggregatszustand in den ersten Raum 45 und in den zweiten Raum 50. Der erste Werkstoff kann ein Gemisch aus einem ersten Vorprodukt und einem zweiten Vorprodukt aufweisen. Beispielsweise kann das erste Vorprodukt Polyisocyanat und das zweite Vorprodukt ein Polyolen aufweisen. Zusätzlich kann dem ersten Werkstoff das erste Partikelmaterial zugemischt sein.

Von besonderem Vorteil ist hierbei, wenn der erste Werkstoff in die beiden Räume 45, 50 im Wesentlichen zeitgleich eingebracht wird. Dabei wird so viel erster Werkstoff in den Raum 45, 50 eingespritzt, bis der erste Werkstoff an der anderen, unverschlossenen Öffnung 100 wieder austritt und der Raum 45, 50 vorzugsweise vollständig mit dem ersten Werkstoff verfüllt ist.

In einem auf den dritten Verfahrensschritt 215 folgenden vierten Verfahrensschritt 220 wird der erste Werkstoff zu dem ersten und zweiten elektrischen Leiter 30, 35 ausgehärtet. Dabei kann beispielsweise der erste Werkstoff erstarren und/oder das erste Vorprodukt mit dem zweiten Vorprodukt zu dem ersten Matrixmaterial vernetzen und beispielsweise Polyurethan ausbilden.

Im fünften Verfahrensschritt 225 wird vorzugsweise ein an der offenen Öffnung 100 ausgetretener ausgehärteter erster Werkstoff mittels eines Schneidmittels abgetrennt. Ferner wird ggf. das Verschlussmittel 105 entfernt. Das Verschlussmittel 105 kann beispielsweise mittels des Schneidmittels abgeschnitten werden.

Die Kontakteinrichtungen 20 bis 24 werden in einem sechsten Verfahrensschritt 230 an den Öffnungen 100 montiert, wobei die Kontakteinrichtungen 20 bis 24 jeweils den zugeordneten ersten und/oder zweiten elektrischen Leiter 30, 35 elektrisch und mechanisch kontaktieren.

Das oben beschriebene Herstellungsverfahren und das elektrische Verteilersystem 10 haben den Vorteil, dass auf einfache Weise das elektrische Verteilersystem 10 hergestellt werden kann. Insbesondere kann eine Geometrie der Ummantelung 25 und somit des Kabelbaums 15 durch Änderung der Druckgeometrie auf einfache Weise adaptiert werden. Dadurch kann der Kabelbaum 15 besonders schnell angepasst werden. Insbesondere eignet sich das beschriebene Verfahren für produktspezifisch schnelle Anpassung von Kabelbäumen 15.

Figur 6 zeigt eine schematische Darstellung eines elektrischen Verteilersystems 10 während des ersten Verfahrensschritts 205 in einem Herstellungsverfahren gemäß einer zweiten Ausführungsform. Figur 7 zeigt eine schematische Darstellung des elektrischen Verteilersystems 10 während des dritten Verfahrensschritts 215 in dem Herstellungsverfahren gemäß der zweiten Ausführungsform.

Das Herstellungsverfahren ist im Wesentlichen identisch zu dem in Figur 3 beschriebenen Herstellungsverfahren ausgebildet. Im Folgenden wird ausschließlich auf die Unterschiede gegenüber dem in Figur 3 beschriebenen Herstellungsverfahren eingegangen.

Im ersten Verfahrensschritt 205 wird, wie bereits oben erläutert, mittels des ersten Druckkopfs 85 die Hohlstruktur 95 3D-gedruckt. Auf den zweiten Verfahrensschritt 210 wird vorzugsweise verzichtet.

Ist die Hohlstruktur 95 so weit abgeschlossen, dass zumindest unterseitig und seitlich der erste Raum 45, der in Figur 2 beispielhaft unterhalb des zweiten Raums 50 angeordnet ist, fertig gedruckt und das Ummantelungsmaterial 90 im Wesentlichen ausgehärtet ist, werden der erste Verfahrensschritt 205, der dritte Verfahrensschritt 215 und der vierte Verfahrensschritt 220 im Wesentlichen zeitgleich durchgeführt. Dabei wird anstatt des Spritzgusses mit einem zweiten Druckkopf 115 der elektrisch leitfähige Werkstoff in den ersten Raum 45 im dritten Verfahrensschritt 215 dadurch eingebracht, dass der erste elektrische Leiter 30 durch den zweiten Druckkopf 115 3D-gedruckt wird. Zeitgleich kann außerhalb eines Druckbereichs des zweiten Druckkopfs 115 der erste Druckkopf 85 weiter die Hohlstruktur 95 drucken (erster Verfahrensschritt 205). Nach Abschluss des Drucks des ersten elektrischen Leiters 30, beispielsweise kann dieser mehrlagig gedruckt sein, kann der erste Druckkopf 85 nach zumindest teilweisem Aushärten des ersten Matrixmaterials oberseitig auf dem ersten elektrischen Leiter 30 die Hohlstruktur 95 weiterdrucken, sodass ein Einsacken der Hohlstruktur 95 im Bereich des ersten Raums 45 vermieden wird.

Der erste, dritte und vierte Verfahrensschritt 205, 215, 220 werden auch für den zweiten elektrischen Leiter 35 und den Druck der Ummantelung 25 umfangsseitig zu dem zweiten elektrischen Leiter 35 im Wesentlichen wie zum ersten elektrischen Leiter 30 ausgeführt.

Auf den fünften Verfahrensschritt 225 kann auf Grund des Drucks sowohl des elektrischen Leiters 30, 35 als auch der Ummantelung verzichtet werden.

Das Verfahren gemäß der zweiten Ausführungsform hat den Vorteil, dass das elektrische Verteilersystem 10 besonders schnell und kostengünstig hergestellt werden kann, da bereits während des Drucks der Hohlstruktur 95 mit dem Verfüllen der bereits gedruckten Räume 45, 50 durch den zweiten Druckkopf 115 begonnen wird. Auch ist die Aushärtezeit, insbesondere des ersten Werkstoffs des elektrischen Leiters 30, 35, verkürzt.

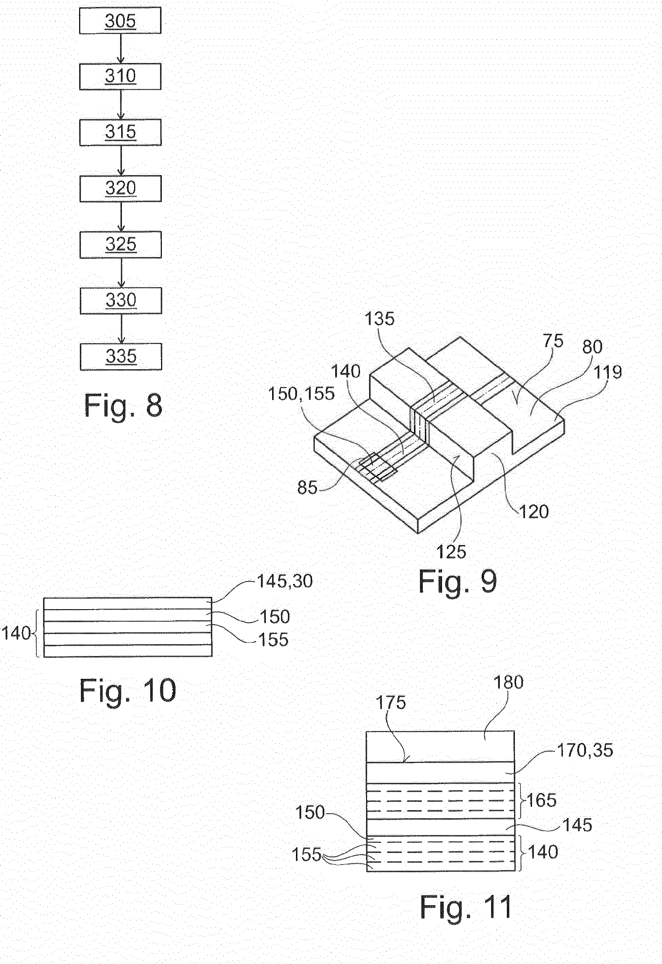

Figur 8 zeigt ein Ablaufdiagramm eines Verfahrens zur Herstellung einer Weiterbildung des in Figur 1 gezeigten Verteilersystems 10. Figur 9 zeigt einen Ausschnitt einer schematische Darstellung eines elektrischen Verteilersystems 10 während eines zweiten Verfahrensschritts 310 in einem Herstellungsverfahren gemäß einer dritten Ausführungsform zur Herstellung des Verteilersystems 10. Figuren 10 und 11 zeigen jeweils einen Ausschnitt einer Schnittansicht des in Figur 9 gezeigten elektrischen Verteilersystems 10 nach einem zweiten und einem siebten Verfahrensschritt 310, 335.

An der Oberseite 75 der in Figur 9 gezeigten Platte 80 ist beispielhaft eine quaderförmig ausgebildete Erhebung 120 angeordnet. Die Erhebung 120 kann beispielsweise ein Karosserieelement eines Kraftfahrzeugs abbilden und diesem bereichsweise nachgebaut sein.

In einem ersten Verfahrensschritt 300 (vgl. Figur 9) wird mittels des ersten Druckkopfs 85 das erste elektrisch nichtleitfähige dielektrische Ummantelungsmaterial 90 entlang einer vordefinierten Bahn 135 zur Ausbildung einer ersten Ummantelungsschicht 140 aufgebracht und vorzugsweise 3D-gedruckt. Das Aufdrucken des Ummantelungsmaterials 90 kann in mehreren übereinander angeordneten ersten und zweiten Lagen 150, 155 erfolgen, um eine gewünschte Schichtdicke der ersten Ummantelungsschicht 140 senkrecht zu der Oberseite 75 zu erhalten. Dabei sind eine oder mehrere erste Lagen 155 der ersten Ummantelungsschicht 140 unterhalb der obersten zweiten Lage 150 der ersten Ummantelungsschicht 140 nach Abschluss des Drucks angeordnet. Auch kann die erste Ummantelungsschicht 140 nur einlagig ausgebildet sein.

In der Ausführungsform druckt beispielhaft der erste Druckkopf 85 die erste Ummantelungsschicht 140 über die Erhebung 120 hinweg, sodass die erste Ummantelungsschicht 140 über eine Seitenfläche 125 der Erhebung 120 geführt ist. Die Seitenfläche 125 ist geneigt, vorzugsweise senkrecht zu der Oberseite 75 der Platte 80 angeordnet. Dabei kann die erste Ummantelungsschicht 140 U-förmig gedruckt werden.

In einem auf den ersten Verfahrensschritt 305 (vgl. Figur 10) folgenden zweiten Verfahrensschritt 310 wird nach Aufbringen des Ummantelungsmaterials 90 und bevor das Ummantelungsmaterial 90 in der obersten zweiten Lage 150 (vollständig) ausgehärtet ist, das heißt, dass das Ummantelungsmaterial 90 zumindest in noch teilweise flüssigem Zustand oder zähflüssigem Zustand in der obersten Lage 150 vorliegt, ein elektrisch leitfähiges zweites Partikelmaterial 145 auf die noch nicht ausgehärtete oberste zweite Lage 150 der ersten Ummantelungsschicht 140 aufgebracht. Das Aufbringen des zweiten Partikelmaterials 145 kann mittels des zweiten Druckkopfs 115 oder durch eine Streueinrichtung erfolgen. Die unter der obersten zweiten Lage 150 angeordneten ersten Lagen 155 sind beim Auftrag des zweiten Partikelmaterials 145 und der obersten zweiten Lage 150 im Wesentlichen vollständig ausgehärtet.

Das zweite Partikelmaterial 145 kann beispielsweise in das noch flüssige Ummantelungsmaterial 90 einsacken und wird dadurch zumindest bereichsweise durch das Ummantelungsmaterial 90 umschlossen. Durch die unter der zweiten Lage 150 angeordneten ausgehärteten ersten Lage 155 wird ein weiteres Absacken des zweiten Partikelmaterials 145 in die erste Lage verhindert, sodass in/auf der obersten zweiten Lage 150 das zweite Partikelmaterial 145 in hoher Konzentration vorliegt.

In einem dritten Verfahrensschritt 315, der zeitlich auf den zweiten Verfahrensschritt 310 folgt, wird das Ummantelungsmaterial 90 der zweiten Lage 155 vollständig ausgehärtet. Dadurch ist das zweite Partikelmaterial 145 an/in der obersten zweiten Lage 150 befestigt.

In einem auf den dritten Verfahrensschritt 315 folgenden vierten Verfahrensschritt 320 wird das zweite Partikelmaterial 145 unter Hitzeeinwirkung gesintert und/oder zumindest teilweise zur Ausbildung des ersten elektrischen Leiters 30 aufgeschmolzen. Das Aufschmelzen kann beispielsweise durch Einbringen thermischer Energie in das zweite Partikelmaterial 145 beispielsweise mittels eines Laserstrahls erfolgen. Das Sintern des zweiten Partikelmaterials 145 kann unter Druck oder drucklos erfolgen. Die zeitlich getrennten Schritte des Aufbringens des zweiten Partikelmaterials 145 auf das Ummantelungsmaterial 90 und das Sintern/Aufschmelzen hat den Vorteil, dass nach dem Sintern und/oder Aufschmelzen des zweiten Partikelmaterials 145 das der erste elektrische Leiter besonders hochohmig ausbildet ist. Der erste elektrische Leiter 30 ist ferner besonders flexibel sowie beispielhaft flach ausgebildet.

Wird beispielsweise die Wärme mittels des Laserstrahls in das zweite Partikelmaterial 145 eingeleitet, ist ein Wärmeeintrag in den Kabelbaum 15 lokal beschränkt. Dies hat den Vorteil, dass die erste Ummantelungsschicht 140 im vierten Verfahrensschritt 320 nicht beispielsweise thermisch beschädigt wird.

Der dritte und vierte Verfahrensschritt 315, 320 können bei geeigneter Wahl des Ummantelungsmaterials 90 auch zeitgleich erfolgen, sodass durch die Wärme zum Sintern und/oder Aufschmelzen auch das Ummantelungsmaterial 90 (fertig) ausgehärtet wird.

Ferner kann in einem fünften Verfahrensschritt 325 (vgl. Figur 11), der auf den vierten Verfahrensschritt 320 folgt, auf das gesinterte/aufgeschmolzene und erstarrte zweite Partikelmaterial 145 das Ummantelungsmaterial 90 zur Ausbildung einer zweiten Ummantelungsschicht 165 mit dem ersten Druckkopf 85 aufgedruckt werden. Der fünfte Verfahrensschritt 325 kann dabei im Wesentlichen identisch zu dem ersten Verfahrensschritt 305 ausgebildet sein. Dabei kann das Ummantelungsmaterial 90 mehrlagig auf das zweite Partikelmaterial 145 aufgedruckt werden, sodass die zweite Ummantelungsschicht 165 eine vordefinierte Dicke nach Abschluss des Druckvorgangs aufweist.

Bevor das Ummantelungsmaterial 90 der zweiten Ummantelungsschicht 165 ausgehärtet ist, wird oberseitig auf die zweite Ummantelungsschicht 165 ein drittes Partikelmaterial 170 aufgebracht. Das noch nicht ausgehärtete Ummantelungsmaterial 90 der zweiten Ummantelungsschicht 165 fixiert das dritte Partikelmaterial 170. Das dritte Partikelmaterial 170 kann mittels der Steuereinrichtung oder dem zweiten Druckkopf 115 aufgebracht werden.

Zeitlich nach Aufbringen des dritten Partikelmaterials 170 auf die zumindest teilweise noch nicht ausgehärtete zweite Ummantelungsschicht 165 wird das Ummantelungsmaterial 90 zur Ausbildung der zweiten Ummantelungsschicht 165 ausgehärtet. Dadurch wird das dritte Partikelmaterial fixiert.

In einem auf dem fünften Verfahrensschritt 325 folgenden sechsten Verfahrensschritt 330, der im Wesentlichen identisch zu dem vierten Verfahrensschritt 320 ausgebildet ist, wird das dritte Partikelmaterial 170 zur Ausbildung des zweiten elektrischen Leiters 35 gesintert und/oder aufgeschmolzen. Nach dem Sintern und/oder Aufschmelzen wird der zweite elektrische Leiter 35 abgekühlt.

Nach Aushärten und/oder Abkühlen des zweiten und dritten Partikelmaterials 145, 170 kann die Kontakteinrichtung 20 bis 24 montiert werden.

Alternativ zu dem beschrieben Verfahren können das zweite Partikelmaterial 145 und das dritte Partikelmaterial 170 gemeinsam unter Hitzeeinwirkung gesintert werden, sodass der vierte Verfahrensschritt 320 und der sechste Verfahrensschritt 330 gemeinsam durchgeführt werden können, sodass das zweite Partikelmaterial 145 den ersten elektrischen Leiter 30 und das dritte Partikelmaterial 170 den zweiten elektrischen Leiter 35 ausbildet. Dies kann beispielsweise in einem Ofen erfolgen.

Um eine Oberseite 75 des zweiten elektrischen Leiters 35 elektrisch zu isolieren und Kerosin zu schützen, kann eine zusätzliche dritte Ummantelungsschicht 180 mit dem ersten Druckkopf 85 auf den zweiten elektrischen Leiter 35 und ggf. auf die zweite Ummantelungsschicht 165 in einem siebten Verfahrensschritt 335 aufgedruckt werden. Dadurch bilden die Ummantelungsschichten 140, 165, 180 die Ummantelung 25 aus.

Diese Ausgestaltung des elektrischen Verteilersystems 10 und dieses Verfahren haben den Vorteil, dass der elektrische Leiter 30, 35 einen besonders niedrigen elektrischen Widerstand aufweist und das elektrische Verteilersystem 10 bzw. der Kabelbaum 15 voll automatisiert und kostengünstig hergestellt werden kann. Durch das Drucken des Kabelbaums 15 kann ferner der Kabelbaum 15 besonders einfach an die zu verbindenden elektrischen Komponenten und in seiner geometrischen Ausgestaltung angepasst werden. Insbesondere kann der Kabelbaum 15 auf Grundlage eines vordefinierten Parametermodells des Kabelbaums 15 automatisiert angepasst werden.

In einer weiteren Weiterbildung des in den Figuren 8 bis 11 beschriebenen Verfahrens wird nach Aushärten des Ummantelungsmaterials 90 und dem Aufschmelzen und/oder Sintern des zweiten Partikelmaterials 145 zum ersten elektrischen Leiter 30 unter Hitzeeinwirkung die erste Ummantelungsschicht 140 entfernt. Dabei kann beispielsweise mittels eines weiteren Laserstrahls die erste Ummantelungsschicht 140 von dem ersten elektrischen Leiter 30 abgebrannt und entfernt werden. Dazu wird vorher das elektrische Verteilersystem 10 von der Platte 80 entfernt werden.

### Bezugszeichenliste

- 10: elektrisches Verteilersystem
- 15: Kabelbaum
- 20-24: erste bis fünfte Kontakteinrichtung
- 25: Ummantelung
- 29: Knickachse
- 30: erster elektrischer Leiter
- 35: zweiter elektrischer Leiter
- 40: Umgebung
- 45: erster Raum
- 50: zweiter Raum
- 55: erste innere Umfangsseite
- 60: äußere Umfangsseite
- 65: zweite innere Umfangsseite
- 70: 3D-Drucker
- 75: Oberseite
- 80: Platte
- 85: erster Druckkopf
- 90: Ummantelungsmaterial
- 95: Hohlstruktur
- 96: Deckel
- 100: Öffnung
- 105: Verschlussmittel
- 110: Spritzgusswerkzeug
- 115: zweiter Druckkopf
- 119: Grundform
- 120: Erhebung
- 125: Seitenfläche
- 135: Bahn
- 140: erste Ummantelungsschicht
- 145: zweites Partikelmaterial
- 150: zweite Lage
- 155: erste Lage
- 165: zweite Ummantelungsschicht
- 170: drittes Partikelmaterial
- 175: Oberseite des zweiten elektrischen Leiters
- 180: dritte Ummantelungsschicht

- 205: erster Verfahrensschritt
- 210: zweiter Verfahrensschritt
- 215: dritter Verfahrensschritt
- 220: vierter Verfahrensschritt
- 225: fünfter Verfahrensschritt
- 230: sechster Verfahrensschritt

- 305: erster Verfahrensschritt
- 310: zweiter Verfahrensschritt
- 315: dritter Verfahrensschritt
- 320: vierter Verfahrensschritt
- 325: fünfter Verfahrensschritt
- 330: sechster Verfahrensschritt
- 335: siebter Verfahrensschritt

## Patentansprüche

1. Verfahren zur Herstellung eines elektrischen Verteilersystems (10),
- wobei ein elektrisch nichtleitendes flüssiges Ummantelungsmaterial (90) entlang einer vordefinierten Bahn (135) zur Ausbildung einer ersten Ummantelungsschicht (140) aufgedruckt wird,
- wobei zeitlich nach Aufbringen des Ummantelungsmaterials (90) ein elektrisch leitfähiges zweites Partikelmaterial (145) auf die erste Ummantelungsschicht (140) zur Ausbildung eines ersten elektrischen Leiters (30) aufgebracht wird,
- wobei die erste Ummantelungsschicht (140) zumindest teilweise das zweite Partikelmaterial (145) fixiert,
- wobei das erste Trägermaterial (130) zeitlich nach Aufbringen des zweiten Partikelmaterials (145) zu der ersten Ummantelungsschicht (140) ausgehärtet wird.

2. Verfahren nach Anspruch 1,
- wobei das elektrisch leitfähige zweite Partikelmaterial (145) auf das flüssige und/oder teilweise ausgehärtete Ummantelungsmaterial (90) der ersten Ummantelungsschicht (140) aufgebracht wird,
- wobei das zweite Partikelmaterial (145) zumindest teilweise durch das Ummantelungsmaterial (90) umschlossen wird.

3. Verfahren nach einem der vorhergehenden Ansprüche,
- wobei zur Herstellung der ersten Ummantelungsschicht (140) eine erste Lage (155) des Ummantelungsmaterials (90) aufgebracht wird und ausgehärtet wird,
- wobei zeitlich nach Aushärten der ersten Lage (155) der ersten Ummantelungsschicht (140) eine zweite Lage (150) der ersten Ummantelungsschicht (140) auf die erste Lage (150) aufgebracht wird,
- wobei das zweite Partikelmaterial auf das flüssige und/oder teilweise ausgehärtete Ummantelungsmaterial (90) der zweiten Lage (150) aufgebracht wird.

4. Verfahren nach einem der vorhergehenden Ansprüche,
- wobei zeitlich nach Aufbringen des zweiten Partikelmaterials (145) das flüssige und/oder teilweise ausgehärtete Ummantelungsmaterial (90) der zweiten Lage (150) fertig ausgehärtet wird,
- wobei das zweite Partikelmaterial (145) unter Hitzeeinwirkung gesintert und/oder zumindest teilweise zur Ausbildung des ersten elektrischen Leiters (30) aufgeschmolzen wird.

5. Verfahren nach Anspruch 4,
- wobei zeitlich nach Ausbilden des ersten elektrischen Leiters (30) die erste Ummantelungsschicht (140) unter Hitzeeinwirkung zumindest teilweise von dem ersten elektrischen Leiter (30) entfernt wird.

6. Verfahren nach einem der vorhergehenden Ansprüche,
- wobei auf das zweite Partikelmaterial (145) das Ummantelungsmaterial (90) zur Ausbildung einer zweiten Ummantelungsschicht (165) aufgedruckt und zu der zweiten Ummantelungsschicht (165) ausgehärtet wird.

7. Verfahren nach Anspruch 6,
- wobei ein elektrisch leitfähiges drittes Partikelmaterial (170) auf die zweite Ummantelungsschicht (165) zur Ausbildung eines zweiten elektrischen Leiters (35) aufgebracht wird,
- wobei die zweite Ummantelungsschicht (165) zumindest teilweise das dritte Partikelmaterial (170) fixiert,
- wobei das Ummantelungsmaterial (90) der zweiten Ummantelungsschicht (165) zeitlich nach Aufbringen des zweiten Partikelmaterials (145) zu der zweiten Ummantelungsschicht (165) ausgehärtet wird und das zweite Partikelmaterial (145) den zweiten elektrischen Leiter (35) ausbildet.

8. Elektrisches Verteilersystem (10), insbesondere Kabelbaum (15), hergestellt mittels eines Verfahrens nach einem der vorhergehenden Ansprüche.

9. Verfahren zur Herstellung eines elektrischen Verteilersystems (10), insbesondere eines Kabelbaums (15),
- wobei eine Ummantelung (25) des elektrischen Verteilersystems (10) mit wenigstens einer Hohlstruktur (95) aus einem elektrisch nichtleitenden flüssigen Ummantelungsmaterial (90) gedruckt wird,
- wobei das Ummantelungsmaterial (90) ausgehärtet wird,
- wobei ein elektrisch leitfähiger Werkstoff in zumindest teilweise flüssigem Aggregatszustand in die Hohlstruktur (95) eingebracht wird und der elektrisch leitfähige Werkstoff zu einem ersten elektrischen Leiter (30) des elektrischen Verteilersystems (10) ausgehärtet wird.

10. Verfahren nach Anspruch 9,
- wobei der elektrisch leitfähige Werkstoff zeitlich nach dem Aushärten des Ummantelungsmaterials (90) in die Hohlstruktur (95) eingebracht wird,
- wobei die Hohlstruktur (95) im Wesentlichen vollständig mit dem elektrisch leitfähigen Werkstoff verfüllt wird.

11. Verfahren nach Anspruch 9 oder 10,
- wobei der elektrisch leitfähige Werkstoff druckbeaufschlagt in die Hohlstruktur (95) eingepresst wird.

12. Verfahren nach einem der Ansprüche 9 bis 11,
- wobei das elektrisch nichtleitende flüssige Ummantelungsmaterial (90)) gedruckt wird und die Hohlstruktur (95) mit einem ersten Raum (45) ausgeformt wird,
- wobei der elektrisch leitfähige Werkstoff in den ersten Raum (45) eingebracht wird,
- wobei das Drucken der Ummantelung (25) und das Einbringen des leitfähigen Werkstoffs in den ersten Raum (45) im Wesentlichen zeitgleich erfolgt.

13. Verfahren nach einem der Ansprüche 9 bis 12,
- wobei der elektrisch leitfähige Werkstoff bei Befüllung der Hohlstruktur (95) ein Gemisch aus wenigstens einem ersten Vorprodukt eines ersten Matrixmaterials und einem elektrisch leitfähigen ersten Partikelmaterial aufweist,
- wobei das erste Vorprodukt zu dem ersten Matrixmaterial ausgehärtet wird und eine stoffschlüssige Verbindung zu der Hohlstruktur (95) ausbildet,
- wobei das erste Partikelmaterial in dem ersten Matrixmaterial eingebettet ist.

14. Elektrisches Verteilersystem (10), insbesondere Kabelbaum (15),
- aufweisend eine Ummantelung (25) und wenigstens einen ersten elektrischen Leiter (30),
- wobei die Ummantelung (25) gedruckt ist, insbesondere 3D-gedruckt, und der elektrische Leiter (30, 35) in die Ummantelung (25) gegossen oder gedruckt ist,
- wobei die Ummantelung (25) zumindest abschnittsweite den ersten elektrischen Leiter (30) umschließt.
